# FASCICULE DE BREVET EUROPEEN

(11) **EP 3 716 333 B1**
(45) Date de publication et mention de la délivrance du brevet: **07.02.2024**
(21) Numéro de dépôt: 20165236.9
(22) Date de dépôt: 24.03.2020
(51) Int. Cl.: H01L 27/146, H01L 31/103

(54) **DISPOSITIF ÉLECTRONIQUE À PHOTODIODE**
ELEKTRONISCHE VORRICHTUNG MIT FOTODIODE
ELECTRONIC PHOTODIODE DEVICE

(30) Priorité: 27.03.2019 FR 1903194
(43) Date de publication de la demande: 30.09.2020
(73) Titulaire: STMicroelectronics (Crolles 2) SAS, 38920 Crolles (FR)
(72) Inventeur: TOURNIER, Arnaud, 38000 GRENOBLE (FR); RODRIGUES GONCALVES, Boris, 38660 LE TOUVET (FR); ROY, François, 38180 SEYSSINS (FR)
(74) Mandataire: Cabinet Beaumont

(56) Documents cités:
- EP-A1- 2 216 817
- EP-A1- 3 696 865
- WO-A1-2018/050996
- US-A1- 2017 125 474
- US-A1- 2018 315 784

## Description

### Domaine technique

La présente description concerne de façon générale les dispositifs électroniques comprenant au moins une photodiode.

### Technique antérieure

Les photodiodes sont des composants semiconducteurs comprenant chacun une jonction PN. Les photodiodes ont la capacité de détecter un rayonnement du domaine optique et de le transformer en signal électrique.

Les capteurs d'images sont des dispositifs électroniques comprenant chacun une pluralité de photodiodes. Les photodiodes permettent au dispositif d'obtenir une image d'une scène à un instant donné. L'image est constituée d'une matrice de pixels, l'information de chaque pixel étant obtenue par une ou plusieurs photodiodes. Par exemple, cette information correspond généralement à une quantité d'électrons obtenue par une photodiode à un instant donné, cette quantité d'électrons étant convertie par le capteur d'images en niveau de couleurs (rouge, vert ou bleu) ou en niveau de gris.

Des électrons ayant été formés après l'instant correspondant à l'image peuvent cependant entraîner des modifications de l'image obtenue par le capteur.

### Résumé de l'invention

Un mode de réalisation pallie tout ou partie des inconvénients des dispositifs à photodiode connus.

Un mode de réalisation prévoit un dispositif électronique, tel que défini dans la revendication 1, comprenant une photodiode, la photodiode comprenant une région reliée à un noeud d'application d'une première tension, la région étant partiellement entourée par au moins un mur semiconducteur s'étendant sur au moins la hauteur de la photodiode.

Selon un mode de réalisation, la photodiode est formée dans un substrat semiconducteur et le ou les murs s'étendent sur toute la hauteur du substrat semiconducteur.

Selon un mode de réalisation, le ou les murs sont reliés à un noeud d'application d'une deuxième tension.

Selon un mode de réalisation, selon la présente invention, au moins un du ou des murs a une forme en U.

Selon un mode de réalisation, la région est située dans la région convexe délimitée par le au moins un du ou des murs en forme en U.

Selon un mode de réalisation, le dispositif comprend deux murs ayant chacun une forme en U.

Selon un mode de réalisation, la région convexe délimitée par chacun des deux murs est dans la direction de l'autre mur.

Selon un mode de réalisation, le dispositif comprend au moins un mur ayant une forme de parallélépipède rectangle.

Selon un mode de réalisation, la région est séparée du ou des murs par une tranchée isolante.

Selon un mode de réalisation, le dispositif comprend un transistor reliant, par sa source et son drain, la cathode de la photodiode à un noeud d'application d'une tension positive.

Selon un mode de réalisation, le dispositif comprend un élément de mémorisation relié à la cathode de la photodiode.

Selon un mode de réalisation, l'élément de mémorisation est une zone de collecte d'électrons.

Selon un mode de réalisation, le dispositif comprend au moins un plot de connexion reposant sur la photodiode relié à un noeud d'application d'une tension positive.

Un autre mode de réalisation prévoit un procédé d'utilisation d'un dispositif électronique tel que précédemment décrit, le procédé comprenant une première étape au cours de laquelle la deuxième tension est une tension négative et une deuxième étape au cours de laquelle la deuxième tension est une tension positive.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un dispositif électronique comprenant une photodiode ;
la figure 2 représente schématiquement, en vue de dessus, un mode de réalisation d'une partie du dispositif électronique comprenant une photodiode de la figure 1 ;
la figure 3 est une vue en coupe selon le plan A-A de la figure 2 et une vue en coupe selon le plan B-B de la figure 2 ; et
la figure 4 représente schématiquement, en vue de dessus, un autre mode de réalisation d'un dispositif électronique comprenant une photodiode.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

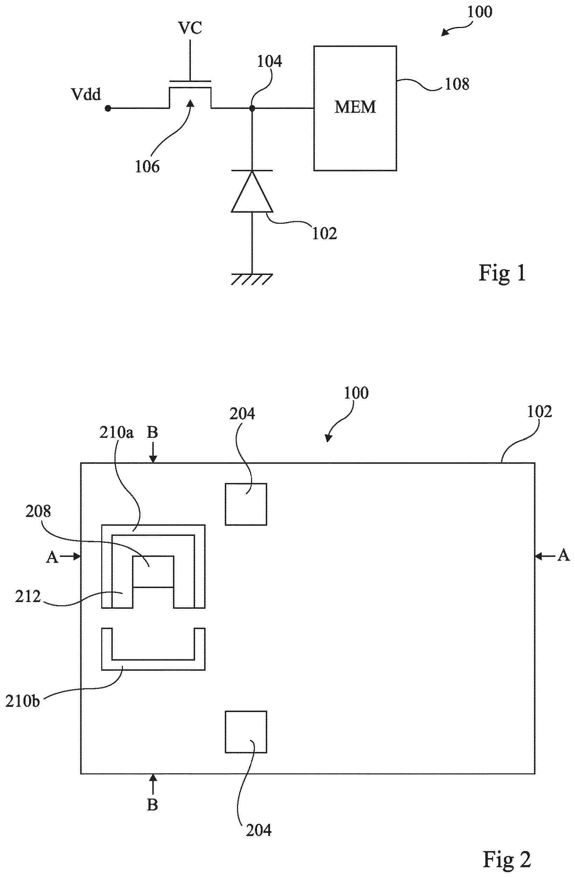

La figure 1 représente schématiquement un dispositif électronique 100 comprenant une photodiode 102. Le dispositif 100 est par exemple une partie d'un capteur d'images, comprenant une pluralité de photodiodes. Par exemple, le dispositif 100 peut être reproduit pour chaque photodiode d'un capteur d'images.

La photodiode 102 est reliée, de préférence connectée, entre un noeud 104 et un noeud d'application d'une première tension de référence, par exemple la masse. Plus précisément, la cathode de la photodiode 102 est reliée, de préférence connectée, au noeud 104 et l'anode de la photodiode 102 est reliée, de préférence connectée, au noeud d'application de la première tension de référence.

Le dispositif 100 comprend de plus un interrupteur 106, de préférence un transistor, relié entre le noeud 104 et un noeud d'application d'une deuxième tension de référence, par exemple une tension d'alimentation positive Vdd. La tension Vdd est par exemple supérieure à 1 V.

Le transistor 106 est par exemple connecté au noeud d'application de la tension Vdd par son drain et au noeud 104 par sa source. La grille du transistor 106 est reliée, de préférence connectée, à un noeud d'application d'une tension de commande VC.

Le noeud 104 est, de plus, relié, de préférence connecté, à un élément de mémorisation 108 MEM.

L'élément de mémorisation 108 est de préférence une zone de collecte d'électrons, par exemple une zone de matériau semiconducteur, adaptée à conserver des électrons ayant été formés par la photodiode 102. Le dispositif 100 peut comprendre un ou plusieurs zones de collecte d'électrons 108.

Le procédé d'utilisation du dispositif 100 comprend de préférence au moins deux étapes, qui seront décrites pour un unique dispositif 100. Dans le cas d'un capteur d'images comprenant une pluralité de dispositifs 100, chaque dispositif 100 met en oeuvre le procédé d'utilisation. De préférence, la pluralité de dispositifs 100 met simultanément en oeuvre chaque étape du procédé. Ainsi, les informations fournies par chaque pixel 102 sont représentatives d'une même scène d'un même instant.

Au cours d'une première étape, l'image de la scène est capturée. Plus précisément, la lumière provenant de la scène à un instant donné entraîne la formation d'électrons dans la photodiode 102. Le nombre d'électrons fournit, par exemple, des informations sur un pixel de l'image qui sera obtenue. Ces électrons sont transférés, au cours de cette première étape, dans une ou plusieurs zones de collecte d'électrons, formant par exemple l'élément de mémorisation 108. Ensuite, la photodiode 102 peut par exemple être couverte.

Le procédé comprend une deuxième étape au cours de laquelle la quantité d'électrons dans les éléments de mémorisation est lue par un circuit adapté non représenté.

Cependant, la lumière peut continuer d'atteindre la photodiode, par exemple si la photodiode n'est pas couverte, ou si la photodiode est partiellement couverte. Des électrons continuent alors d'être formés et risquent d'être transférés dans la ou les zones de stockage d'électrons. La quantité d'électrons serait alors modifiée, de même que les informations représentatives de l'image, qui ne correspondraient plus à l'image de la scène à l'instant choisi. L'interrupteur 106 est alors fermé durant la deuxième étape de manière à relier le noeud 104 au noeud d'application de la tension Vdd. Les électrons sont ainsi attirés vers le noeud d'application de la tension Vdd et non vers l'élément de mémorisation 108.

A titre de variante, dans le cas où le capteur d'images comprend une pluralité de dispositifs 100, certaines parties des dispositifs 100 peuvent être communes à plusieurs des dispositifs 100. Par exemple, l'interrupteur 106 peut être commun à plusieurs dispositifs 100.

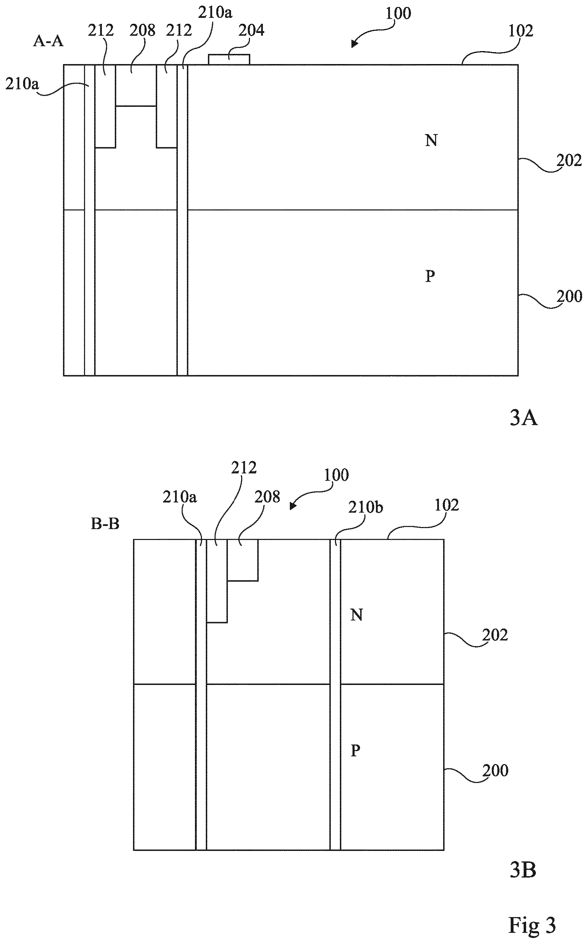

La figure 2 représente schématiquement, en vue de dessus, un mode de réalisation d'une partie du dispositif électronique 100 comprenant une photodiode 102. La figure 3 comprend une vue 3A en coupe selon le plan A-A de la figure 2 et une vue 3B en coupe selon le plan B-B de la figure 2.

La photodiode 102 comprend une jonction PN dans un substrat semiconducteur. La photodiode comprend par exemple une couche 200 semiconductrice de type P recouverte d'une couche 202 semiconductrice de type N. Les couches 200 et 202 sont par exemple en silicium. La couche 202 constitue aussi la source du transistor 106, reliée avec la cathode de la photodiode.

Le dispositif 100 comprend deux plots de contact 204 situés par exemple sur la surface supérieure de la photodiode 102. Les plots 204 sont par exemple situés sur la face supérieure de la couche semiconductrice 202.

Les plots de contact 204 sont par exemple reliés, de préférence connectés, à des noeuds d'application d'une tension de commande. Les deux plots sont par exemple reliés, chacun par l'intermédiaire d'un interrupteur, à un même noeud d'application d'une même tension de commande. Cette tension de commande est apte à entraîner le mouvement des électrons vers les zones de collecte d'électrons. Cette tension de commande est par exemple une tension positive de valeur égale à la tension d'alimentation Vdd.

Les zones de collecte d'électrons sont par exemple des régions semiconductrices adjacentes à la photodiode 102. Chaque plot de contact 204 est de préférence situé en regard d'une interface de contact entre la photodiode 102 et une des zones de collecte d'électrons. A l'exception de l'interface de contact, la photodiode 102 et la zone de collecte sont par exemple séparées par un mur isolant, ou un mur semiconducteur recevant une tension négative, non représenté. A titre de variante, plusieurs plots 204 peuvent être situés en regard d'une même interface de contact entre la photodiode 102 et une des zones de collecte d'électrons.

Dans l'exemple des figures 2 et 3, le dispositif comprend deux plots 204 et donc comprend par exemple deux zones de collecte d'électrons. De manière plus générale, le dispositif peut comprendre au moins un plot 204, et donc au moins une zone de collecte d'électrons.

Durant la première étape, décrite précédemment, une tension positive VP, par exemple la tension d'alimentation Vdd, est fournie à au moins un des plots 204 de manière à attirer les électrons vers lui et donc vers la zone de collecte d'électrons correspondante. Dans le cas où il y a plusieurs plots 204 et plusieurs zones de collecte d'électrons, les plots 204 reçoivent par exemple la tension positive l'une après l'autre alternativement pour que les électrons soient partiellement stockés dans chacune des zones de collecte d'électrons. Cela permet d'échantillonner l'information obtenue par la photodiode 102.

Les plots de connexion 204 sont par exemple des éléments surfaciques, c'est-à-dire qu'ils sont en contact avec une face de la photodiode 102, par exemple uniquement avec la face supérieure de la couche semiconductrice 202. Par exemple, les plots de connexion 204 ne sont en contact avec la photodiode 102 que par une unique surface plane. Les plots de contact 204 sont par exemple des plaques ou des couches conductrices, par exemple en métal, reposant sur la photodiode 102.

Le dispositif 100 comprend, de plus, une région semiconductrice 208 située dans la photodiode 102. La région 208 est par exemple située dans la couche semiconductrice 202. La région 208 est dans cet exemple du même type de dopage que la couche 202, par exemple dopée de type N. La région 208 est par exemple plus fortement dopée que la couche semiconductrice 204. La région 208 s'étend dans la couche semiconductrice 202, par exemple à partir de la face supérieure de la photodiode 102, c'est-à-dire par exemple à partir de la face supérieure de la couche 202. La région 208 ne s'étend pas, de préférence, sur toute la hauteur de la couche semiconductrice 202.

La région 208 est reliée, de préférence connectée, au noeud d'application de la tension d'alimentation Vdd. La région 208 constitue le drain du transistor 106 (figure 1).

Le dispositif 100 comprend, de plus, deux murs semiconducteurs 210 (210a et 210b en figures 2 et 3). De manière plus générale, le dispositif 100 comprend au moins un mur semiconducteur 210 entourant partiellement la région 208. Les murs 210 sont par exemple en un semiconducteur intrinsèque. Les murs 210 sont par exemple en silicium. Les murs 210 s'étendent sur au moins toute la hauteur de la photodiode, c'est-à-dire sur la hauteur des couches 200 et 202. De préférence, les murs 210 s'étendent sur toute la hauteur du substrat dans lequel est formée la photodiode 102.

Le mur 210a a, en vue de dessus, une forme de U. Le mur 210a a donc une section en forme de U dans un plan parallèle à la face supérieure de la couche 202. Le mur 210a comprend deux premières branches sensiblement parallèles l'une à l'autre, reliées par une deuxième branche sensiblement perpendiculaire aux deux premières branches.

Le mur 210b a aussi, en vue de dessus, une forme de U. Le mur 210b a donc une section en forme de U dans un plan parallèle à la face supérieure de la couche 202. Le mur 210b comprend deux premières branches sensiblement parallèles l'une à l'autre, reliées par une deuxième branche sensiblement perpendiculaire aux deux premières branches.

Les murs 210a et 210b sont situés dans la photodiode, c'est-à-dire à l'intérieur de la photodiode. Les murs 210a et 210b s'étendent à travers les couches semiconductrices formant la jonction PN de la photodiode. Les murs 210a et 210b sont entourés par les couches semiconductrices formant la jonction PN de la photodiode. L'ensemble comprenant les murs 210a et 210b, la région 208 et la tranchée 212 est entouré par les couches semiconductrices formant la jonction PN de la photodiode.

De préférence, les premières branches du mur 210b sont moins longues que les premières branches du mur 210a. De plus, la longueur de la deuxième branche du mur 210a est sensiblement égale à la longueur de la deuxième branche du mur 210b.

Les premières branches de chaque mur 210a et 210b ont par exemple sensiblement la même largeur. De même, les deuxièmes branches de chaque mur 210a et 210b ont par exemple la même largeur. De plus, les premières et deuxième branches d'un même mur ont par exemple sensiblement la même largeur. Cette largeur commune est par exemple comprise entre 100 nm et 500 nm.

Les murs 210a et 210b sont situés l'un en face de l'autre. Plus précisément, les premières branches du mur 210a sont situées dans le prolongement des premières branches du mur 210b. De préférence, la région interne du mur 210a est en face de la région interne du mur 210b, c'est-à-dire que les premières branches des murs 210a et 210b sont situées entre les deuxièmes branches des murs 210a et 210b. Autrement dit, la région convexe délimitée par la forme en U de chacun des deux murs, c'est-à-dire la région située entre les premières branches, est en direction de l'autre mur 210.

Les murs 210a et 210b sont espacés l'un de l'autre, c'est-à-dire qu'ils ne sont pas en contact l'un avec l'autre. Les murs 210a et 210b sont ainsi séparés l'un de l'autre par une portion des couches semiconductrices 200 et 202.

La région semiconductrice 208 est située à l'intérieur de la forme en U du mur 210a, c'est-à-dire entre les deux premières branches du mur 210a. Autrement dit, la région 208 est située dans la région convexe délimitée par la forme en U. La région 208 est donc partiellement entourée par les murs 210a et 210b.

L'espace entre les extrémités des premières branches des murs 210a et 210b peut permettre le passage d'électrons dans les couches 200 et 202 de manière à atteindre la région semiconductrice 208.

La longueur des premières branches est cependant de préférence suffisante pour qu'une première branche se situe entre la région 208 et les plots 204. De plus, les murs 210 sont situés entre la région 208 et les zones de collecte d'électrons.

Les murs 210 constituent la grille du transistor 106 (figure 1). Les murs 210 sont reliés, de préférence connectés, à un noeud d'application de la tension de commande VC.

La région 208 est séparée du mur 210a par une tranchée isolante 212. La région 208 n'est de préférence séparée du mur 210a que par la tranchée isolante 212. Ainsi, il n'y a, de préférence, pas de portion de la couche semiconductrice 202 entre la région 208 et le mur 210a.

La tranchée isolante 212 s'étend dans la couche semiconductrice 202, par exemple à partir de la face supérieure de la couche semiconductrice 202. La tranchée isolante 212 est au moins aussi profonde que la région 208. La tranchée isolante 212 est de préférence moins profonde que les murs 210.

Lors de la première étape décrite précédemment, la tension de commande VC est une tension négative, par exemple inférieure ou égale à -1 V. Les plots de contact 204 reçoivent, de manière continue ou alternée, la tension positive VP. Ainsi, les électrons formés dans la photodiode 102 sont attirés vers les zones de collecte d'électrons.

Lors de la deuxième étape, la tension de commande VC est une tension positive, par exemple égale à la tension d'alimentation Vdd. De plus, la tension VP est une tension négative, par exemple inférieure ou égale à -0,5 V. Ainsi, les électrons sont attirés, d'abord, par les murs 210 puis par la région semiconductrice 208. Pour ce faire, les électrons passent par l'espace entre les murs 210a et 210b. Ces électrons ne sont pas attirés dans les zones de stockage d'électrons, et ne modifient pas la quantité d'électrons stockés.

L'interface entre les murs 210 et la photodiode est volumique. En effet, les murs 210 sont situés dans la photodiode 102. Plusieurs faces des murs 210, les faces latérales, sont en contact avec la photodiode 102. De plus, les murs 210 sont en contact avec des parties internes de la photodiode 102. Cela a pour avantage d'attirer des électrons situés dans la partie inférieure de la photodiode. En effet, on aurait pu choisir de former des plots semiconducteurs de forme similaire aux plots 204 et situés sur la face supérieure de la photodiode 102. Cependant, les électrons situés dans la partie inférieure de la photodiode risqueraient de ne pas être attirés par les murs 210 et risqueraient d'être attirés dans les éléments de mémorisation.

A titre de variante, le mur 210b peut ne pas comprendre de premières branches. Le mur 210b a ainsi la forme d'un parallélépipède rectangle.

A titre de variante, le dispositif 100 peut comprendre un unique mur semiconducteur entourant la région 208 à l'exception d'une ouverture, par exemple du côté des plots 204. Par exemple, le mur correspond aux murs 210, dont les premières branches les plus éloignées des plots 204 sont en contact de manière à former une unique branche s'étendant d'une des deuxièmes branches à l'autre. La séparation des autres premières branches est néanmoins présente.

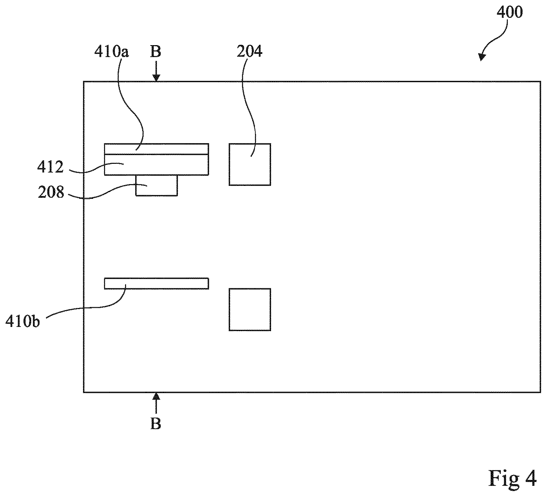

La figure 4 représente schématiquement, en vue de dessus, un autre exemple d'un dispositif électronique 400 comprenant une photodiode 102 similaire à la photodiode du mode de réalisation des figures 2 et 3. La vue en coupe selon le plan B-B de la figure 4 est similaire à la vue 3B de la figure 3. Le dispositif 400 a une structure similaire à la structure du dispositif 100 décrit en figure 1.

La photodiode 102 comprend, comme précédemment, une jonction PN dans un substrat semiconducteur. La photodiode comprend par exemple la couche 200 semiconductrice de type P recouverte de la couche 202 semiconductrice de type N. Les couches 200 et 202 sont par exemple en silicium. La couche 202 constitue aussi la source du transistor 106, en contact avec la cathode de la photodiode 102.

Le dispositif 400 comprend les deux plots de contact 204 situés par exemple sur la surface supérieure de la photodiode 102. Les plots 204 sont par exemple situés sur la face supérieure de la couche semiconductrice 202.

Les plots de contact 204 sont par exemple reliés, de préférence connectés, à des noeuds d'application d'une tension de commande. Les deux plots sont par exemple reliés, chacun par l'intermédiaire d'un interrupteur, à un même noeud d'application d'une même tension de commande. Cette tension de commande est apte à entraîner le mouvement des électrons vers les zones de collecte d'électrons. Cette tension de commande est par exemple une tension positive de valeur égale à la tension d'alimentation.

Les zones de collecte d'électrons sont par exemple des régions semiconductrices adjacentes à la photodiode 102. Chaque plot de contact 204 est de préférence situé en regard d'une interface de contact entre la photodiode 102 et une des zones de collecte d'électrons. A l'exception de l'interface de contact, la photodiode 102 et la zone de collecte sont par exemple séparées par un mur isolant, ou un mur semiconducteur recevant une tension négative, non représenté. A titre de variante, plusieurs plots 204 peuvent être situés en regard d'une même interface de contact entre la photodiode 102 et une des zones de collecte d'électrons.

Dans l'exemple de la figure 4, comme dans l'exemple des figures 2 et 3, le dispositif 400, comme le dispositif 100 dans les figures 2 et 3, comprend deux plots 204 et donc comprend par exemple deux zones de collecte d'électrons. De manière plus générale, le dispositif 400 peut comprendre au moins un plot 204, et donc au moins une zone de collecte d'électrons.

Le dispositif 400 de la figure 4 met en oeuvre les étapes de fonctionnement décrites précédemment, en relation avec la figure 1.

Durant la première étape décrite précédemment, la tension positive VP, par exemple la tension d'alimentation Vdd, est fournie à au moins un des plots 204 de manière à attirer les électrons vers lui et donc vers la zone de collecte d'électrons correspondante. Dans le cas où il y a plusieurs plots 204, les plots reçoivent par exemple la tension positive alternativement pour que les électrons soient partiellement stockés dans chacune des zones de collecte d'électrons. Cela permet d'échantillonner l'information obtenue par la photodiode 102.

Les plots de connexion 204 sont par exemple des éléments surfaciques, c'est-à-dire qu'ils sont en contact avec une face de la photodiode 102, par exemple uniquement avec la face supérieure de la couche semiconductrice 202. Par exemple, les plots de connexion 204 ne sont en contact avec la photodiode 102 que par une unique surface plane. Les plots de contact 204 sont par exemple des plaques ou des couches conductrices, par exemple en métal, reposant sur la photodiode 102.

Le dispositif 400 comprend, de plus, la région semiconductrice 208 située dans la photodiode 102. La région 208 est par exemple située dans la couche semiconductrice 202. La région 208 est dans cet exemple du même type de dopage que la couche 202, par exemple dopée de type N. La région 208 est par exemple plus fortement dopée que la couche semiconductrice 204. La région 208 s'étend dans la couche semiconductrice 202, par exemple à partir de la face supérieure de la photodiode 102, c'est-à-dire par exemple à partir de la face supérieure de la couche 202. La région 208 ne s'étend pas, de préférence, sur toute la hauteur de la couche semiconductrice 202.

La région 208 est reliée, de préférence connectée, au noeud d'application de la tension d'alimentation Vdd. La région 208 constitue le drain du transistor 106 (figure 1).

Le dispositif 400 comprend, comme le dispositif 100, des murs semiconducteurs 410. Le dispositif 400 comprend deux murs semiconducteurs 410 (410a et 410b en figure 4). Les murs 410 sont par exemple en un semiconducteur intrinsèque. Les murs 210 sont par exemple en silicium. Les murs 410 s'étendent sur au moins toute la hauteur de la photodiode, c'est-à-dire sur la hauteur des couches 200 et 202. De préférence, les murs 410 s'étendent sur toute la hauteur du substrat dans lequel est formée la photodiode 102.

Chacun des murs 410 de l'exemple de la figure 4 a, contrairement aux murs 210, sensiblement la forme d'un parallélépipède rectangle. Les murs 410a et 410b sont parallèles l'un par rapport à l'autre. Les murs 410a et 410b ont par exemple la forme et l'emplacement des deuxièmes branches des murs 210a et 210b du mode de réalisation des figures 2 et 3.

Les murs 410a et 410b sont espacés l'un de l'autre, c'est-à-dire qu'ils ne sont pas en contact l'un avec l'autre. Les murs 410a et 410b sont ainsi séparés l'un de l'autre par une région des couches semiconductrices 200 et 202.

La région semiconductrice 208 est située entre les murs 410a et 410b, dans la région de la couche semiconductrice 202. La région 208 est donc partiellement entourée par les murs 410a et 410b.

L'espace entre les murs 410a et 410b peut permettre le passage d'électrons dans les couches 200 et 202 de manière à atteindre la région semiconductrice 208.

Les murs 410 constituent la grille du transistor 106 (figure 1). Les murs 410 sont reliés, de préférence connectés, à un noeud d'application de la tension de commande VC.

La région 208 est séparée du mur 410a par une tranchée isolante 412. La région 208 n'est de préférence séparée du mur 410a que par la tranchée isolante 412. Ainsi, il n'y a, de préférence, pas de portion de la couche semiconductrice 202 entre la région 208 et le mur 410a.

La tranchée isolante 412 s'étend dans la couche semiconductrice 202, par exemple à partir de la face supérieure de la couche semiconductrice 202. La tranchée isolante 412 est au moins aussi profonde que la région 208. La tranchée isolante 212 est de préférence moins profonde que les murs 410.

Lors de la première étape décrite précédemment, la tension de commande VC est une tension négative, par exemple inférieure ou égale à -1 V. Les plots de contact 204 reçoivent, de manière continue ou alternée, la tension positive VP. Ainsi, les électrons formés dans la photodiode 102 sont attirés vers les zones de collecte d'électrons.

Lors de la deuxième étape, la tension de commande VC est une tension positive, par exemple égale à la tension d'alimentation Vdd. De plus, la tension VP n'est plus fournie aux plots de contact 204. Ainsi, les électrons sont attirés, d'abord, par les murs 410 puis par la région semiconductrice 208. Pour ce faire, les électrons passent entre les murs 410a et 410b. Ces électrons ne sont pas attirés dans les zones de stockage d'électrons, et ne modifient pas la quantité d'électrons stockés.

L'interface entre les murs 410 et la photodiode est volumique. En effet, les murs 410 sont situés dans la photodiode 102. Plusieurs faces des murs 410, les faces latérales, sont en contact avec la photodiode 102. De plus, les murs 410 sont en contact avec des parties internes de la photodiode 102. Cela a pour avantage d'attirer des électrons situés dans la partie inférieure de la photodiode. En effet, on aurait pu choisir de former des plots semiconducteurs de forme similaire aux plots 204 et situés sur la face supérieure de la photodiode 102. Cependant, les électrons situés dans la partie inférieure de la photodiode risqueraient de ne pas être attirés par les murs 410 et risqueraient d'être attirés dans les éléments de mémorisation.

A titre de variante, les murs semiconducteurs peuvent avoir des formes différentes, en entourant partiellement la région semiconductrice 208. Par exemple, le dispositif 400 comprend un unique mur 410a et ne comprend pas le mur 410b.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits peuvent être adaptés de manière à fonctionner de manière équivalente pour des trous à la place des électrons.

De plus, la photodiode peut être différente de celle décrite. Par exemple, la photodiode peut ne pas comprendre une jonction PN horizontale, comme c'est le cas dans les modes de réalisation décrits, mais une jonction PN verticale.

En outre, les types de dopage des différents éléments décrits peuvent être inversés.

Enfin, la mise en oeuvre pratique des modes de réalisation et variantes décrits est à la portée de l'homme du métier à partir des indications fonctionnelles données ci-dessus.

## Revendications

1. Dispositif électronique (100, 400) comprenant une photodiode (102) formée dans un substrat semiconducteur, la photodiode comprenant une région (208) reliée à un noeud d'application d'une première tension (Vdd), la région étant partiellement entourée par au moins un mur semiconducteur (210a, 210b, 410a, 410b) s'étendant sur au moins la hauteur de la photodiode (102) **caractérisé en ce que** le au moins un mur semiconducteur étant situé dans la photodiode, au moins un du ou des murs (210a, 210b) ayant une forme en U, en vue de dessus.

2. Dispositif selon la revendication 1, dans lequel le ou les murs (210a, 210b, 410a, 410b) s'étendent sur toute la hauteur du substrat semiconducteur.

3. Dispositif selon la revendication 1 ou 2, dans lequel le ou les murs (210a, 210b, 410a, 410b) sont reliés à un noeud d'application d'une deuxième tension (VC).

4. Dispositif selon l'une quelconque des revendications 1 à 3, dans lequel la région (208) est située dans la région convexe délimitée par le au moins un du ou des murs en forme en U.

5. Dispositif selon l'une quelconque des revendications 1 à 4, comprenant deux murs (210a, 210b) ayant chacun une forme en U.

6. Dispositif selon la revendication 5, dans lequel la région convexe délimitée par chacun des deux murs (210a, 210b) est dans la direction de l'autre mur.

7. Dispositif selon l'une quelconque des revendications 1 à 6, comprenant au moins un mur (410a, 410b) ayant une forme de parallélépipède rectangle.

8. Dispositif selon l'une quelconque des revendications 1 à 7, dans lequel la région (208) est séparée du ou des murs par une tranchée isolante (212, 412).

9. Dispositif selon l'une quelconque des revendications 1 à 8, comprenant un transistor (106) reliant, par sa source et son drain, la cathode de la photodiode (102) à un noeud d'application d'une tension positive.

10. Dispositif selon la revendication 9, comprenant un élément de mémorisation (108) relié à la cathode de la photodiode (102) .

11. Dispositif selon la revendication 10, dans lequel l'élément de mémorisation (108) est une zone de collecte d'électrons.

12. Dispositif selon l'une quelconque des revendications 1 à 11, comprenant au moins un plot de connexion (204) reposant sur la photodiode (102) relié à un noeud d'application d'une tension positive.

13. Procédé d'utilisation d'un dispositif électronique selon l'une quelconque des revendications 1 à 12, le procédé comprenant une première étape au cours de laquelle la deuxième tension est une tension négative et une deuxième étape au cours de laquelle la deuxième tension est une tension positive.

## Patentansprüche

1. Elektronische Vorrichtung (100, 400) aufweisend eine in einem Halbleitersubstrat ausgebildeten Fotodiode (102), wobei die Fotodiode einen Bereich (208) aufweist, der mit einem Knoten zum Anlegen einer ersten Spannung (Vdd) gekoppelt ist, wobei der Bereich teilweise von mindestens einer Halbleiterwand (210a, 21 0b, 410a, 410b) umgeben ist, die sich zumindest bis zur Höhe der Fotodiode (102) erstreckt, **dadurch gekennzeichnet, dass** die mindestens eine Halbleiterwand in der Fotodiode angeordnet ist, wobei mindestens eine Wand bzw. eine der Wände (210a, 210b) in der Draufsicht U-förmig ist.

2. Vorrichtung nach Anspruch 1, wobei sich die Wand bzw. die Wände (210a, 210b, 410a, 410b) über die gesamte Höhe des Halbleitersubstrats erstrecken.

3. Vorrichtung nach Anspruch 1 oder 2, wobei die Wand bzw. die Wände (210a, 210b, 410a, 410b) mit einem Knoten zum Anlegen einer zweiten Spannung (VC) gekoppelt sind.

4. Vorrichtung nach einem der Ansprüche 1 bis 3, wobei sich der Bereich (208) in dem konvexen Bereich befindet, der durch die mindestens eine U-förmige Wand bzw. die mindestens eine der U-förmigen Wände begrenzt wird.

5. Vorrichtung nach einem der Ansprüche 1 bis 4, wobei die Vorrichtung zwei Wände (210a, 210b) aufweist, die jeweils U-förmig sind.

6. Vorrichtung nach Anspruch 5, wobei sich der konvexe Bereich, der von jeder der beiden Wände (210a, 210b) begrenzt wird, in Richtung der anderen Wand erstreckt.

7. Vorrichtung nach einem der Ansprüche 1 bis 6, mit mindestens einer Wand (410a, 410b), die eine rechteckige Parallelepipedform aufweist.

8. Vorrichtung nach einem der Ansprüche 1 bis 7, wobei der Bereich (208) durch einen isolierenden Graben (212, 412) von der Wand den Wänden getrennt ist.

9. Vorrichtung nach einem der Ansprüche 1 bis 8, mit einem Transistor (106), der über seine Source und sein Drain die Kathode der Fotodiode (102) mit einem Knoten zum Anlegen einer positiven Spannung koppelt.

10. Vorrichtung nach Anspruch 9, aufweisend ein Speicherelement (108), das mit der Kathode der Fotodiode (102) gekoppelt ist.

11. Vorrichtung nach Anspruch 10, wobei das Speicherelement (108) ein Elektronensammelgebiet ist.

12. Vorrichtung nach einem der Ansprüche 1 bis 11, aufweisend mindestens eine auf der Fotodiode (102) aufliegende Anschlussfläche (204), die mit einem Knoten zum Anlegen einer positiven Spannung gekoppelt ist.

13. Verfahren zur Verwendung der elektronischen Vorrichtung nach einem der Ansprüche 1 bis 12, wobei das Verfahren einen ersten Schritt aufweist, bei dem die zweite Spannung eine negative Spannung ist, und einen zweiten Schritt, bei dem die zweite Spannung eine positive Spannung ist.

## Claims

1. An electronic device (100, 400) comprising a photodiode (102) formed in a semiconductor substrate, the photodiode comprising a region (208) coupled to a node of application of a first voltage (Vdd), the region being partially surrounded with at least one semiconductor wall (210a, 210b, 410a, 410b) extending along at least the height of the photodiode (102), **characterized in that** the at least one semiconductor wall is located in the photodiode, at least one of the wall(s) (210a, 210b) being U-shaped in top view.

2. The device of claim 1, wherein the wall(s) (210a, 210b, 410a, 410b) extend along the entire height of the semiconductor substrate.

3. The device of claim 1 or 2, wherein the wall(s) (210a, 210b, 410a, 410b) are coupled to a node of application of a second voltage (VC).

4. The device according to any of claims 1 to 3, wherein the region (208) is located in the convex region delimited by the at least one of the U-shaped wall(s).

5. The device according to any of claims 1 to 4, comprising two walls (210a, 210b), each being U-shaped.

6. The device of claim 5, wherein the convex region delimited by each of the two walls (210a, 210b) extends in the direction of the other wall.

7. The device according to any of claims 1 to 6, comprising at least one wall (410a, 410b) having a rectangular parallelepiped shape.

8. The device according to any of claims 1 to 7, wherein the region (208) is separated from the wall(s) by an insulating trench (212, 412).

9. The device according to any of claims 1 to 8, comprising a transistor (106) coupling, by its source and its drain, the cathode of the photodiode (102) to a node of application of a positive voltage.

10. The device of claim 9, comprising a storage element (108) coupled to the cathode of the photodiode (102).

11. The device of claim 10, wherein the storage element (108) is an electron collection area.

12. The device according to any of claims 1 to 11, comprising at least one connection pad (204) resting on the photodiode (102) coupled to a node of application of a positive voltage.

13. A method of use of the electronic device according to any of claims 1 to 12, the method comprising a first step during which the second voltage is a negative voltage and a second step during which the second voltage is a positive voltage.
